# EUROPEAN PATENT APPLICATION

(11) **EP 2 666 956 A1**
(43) Date of publication of application: **27.11.2013**
(21) Application number: 12460023.0
(22) Date of filing: 21.05.2012
(51) Int. Cl.: E21B 33/035, H02J 3/36, E21B 41/00, E21B 33/037, H05K 5/06, E21B 47/01

(54) **A modular electric system located under water**

(71) Applicant: ABB Technology AG, 8050 Zürich (CH)
(72) Inventor: Piasecki, Wojciech, 30-009 Krakow (PL); Szewczyk, Marcin, 03-982 Warszawa (PL); Stosur, Mariusz, 58-130 Imbramowice (PL); Nalepa, Radoslaw, 59-720 Raciborowice (PL); Wiik, Jan, 0575 Oslo (NO); Bjornstad, Eiril, Oslo (NO)
(74) Representative: Chochorowska-Winiarska, Krystyna

(57) **Abstract**

The invention deals with a modular electric device located under water and operating under high pressure in water environment at large depths, in which electric and power electronic systems are protected against the mechanical effect of high pressure, applicable to energizing induction motors driving rotating machinery. The device is especially suitable for powering underwater oil and gas production systems. The modular electric system (1) is placed under water in a watertight container (2) which is provided with electric bushings (6) and comprising at least one electric system (4) which comprises modular functional electrical elements (8) placed in a protective insulating capsule (9). The electric system (4) is located in a closed container (2) filled with a dielectric non-compressible liquid (3) of a pressure similar to the pressure surrounding the container (2) from external side of the container. At least one of the protective capsules (9) contains an insulating medium (11) of a pressure significantly lower than the pressure in the container (2) and is furnished with means (12) and/or (23) for transferring heat generated in modular functional electrical elements (8).

## Description

The invention deals with a modular electric system located under water and operating under high pressure in water environment at large depths, in which electric and power electronic systems are protected against the mechanical effect of high pressure, applicable to energizing subsea located electrical equipment. The system is especially suitable for powering underwater oil and gas production systems.

### State of the art

Patent description US No. 4 309 734 presents a system and apparatus limiting electric current in offshore oil extraction installations, comprising a current sensing circuit, a logic circuit, and a protector circuit, intended for automatically limiting the current of the inductive coupler which occurs in the inductive coupler as a result of an emergency condition or in consequence of separating the coupler windings in order to disconnect the power consumer from the power supply, and for automatically restoring the system to normal operating conditions after the cause of excessive current flow in the primary winding of the coupler ceases. The presented description shows an example of an arrangement of electric and electronic systems used in water environment at large depths, which is intended for powering oil production systems.

Patent description EP1963616 presents electrical power system for a subsea system comprising at least one subsea power distribution system receiving power from a power source. This power distribution system comprising at least one electrical functional component and at least one connecting member for electrical load or loads. The power distribution system is provided with the first pressurised casing. The functional component is provided with the second pressurised casing. Both casings are arranged in two-stage pressure system. The electrical power system connectable to at least one cable for power transmission from the power source to the subsea system.

The presented solutions do not solve the problem of protecting electric and electronic systems generating power losses in the form of heat, located at large depths in water environment against the effect of high pressure, because it does not solve problems connected with necessary cooling by means of carrying away heat generated in electric and electronic systems as a result of the flow of electric current through such equipment.

### The essence of the invention

A modular electric system is placed under water in a watertight container provided with electric bushings and comprises at least one electric system with modular functional electrical elements placed in protective insulating capsules. The watertight container is filled with a dielectric non-compressible liquid of pressure similar to the pressure surrounding the container from its external side. At least one of the protective insulating capsules contains an insulating medium of a pressure significantly lower than the pressure in the container and is furnished with means for transferring heat generated by modular functional electrical elements.

Preferably the means for transferring heat generated in modular functional electrical elements are made of electrically conductive material placed in the penetrators located in the wall of the capsule and have an electrical connection to the modular functional electrical element.

Preferably the means for transferring heat generated in modular functional electrical elements are located in the wall of the capsule extending from the inside of the wall to the outside of the protective capsule.

Preferably the electric system placed in the watertight container contains an inverter for converting the direct current voltage into alternating current voltage.

Preferably the inverter module is connected by wireless communication means with a control system placed in the watertight container.

Preferably the inverter module of the electric system contains power electronic switches located outside the protective capsule which are connected with wireless communication means of the inverter placed inside the capsule.

Alternatively the inverter module of the electric system contains power electronic switches located inside the protective capsule which are connected with wireless communication means of the inverter placed inside the capsule and the inverter module has a radiator tightly fitted in the wall of the capsule.

Preferably the watertight container is provided with a component that compensates for the pressure inside the container, in the form of compensating bellows.

Preferably in a system according to claims 1 to 8 the dielectric liquid that fills the container is oil and the insulating medium filling the capsules is an electrically insulating gas or a porous substance of compressible properties, or a dielectric liquid with a pressure compensator.

Preferably in a system according to claim 1 to 12 the capsule is made of an epoxy resin-based composite material or is made of elastomer.

### Advantages

The advantage of the invention is a full protection of the equipment of the electric and electronic systems located at a large depth in water environment against the effect of high pressure. By dividing the electric systems of the device into modules which are locked in a closed vessel filled with a medium of a pressure similar to the pressure of water outside the container and by providing individual, selected modules with protective capsules, a stable protection of delicate electric power components is achieved, which results in extended failure-free operation of the whole electric and control systems located under water. Using the container filled with a dielectric non-compressible liquid in which the_electric system with the modular functional electrical elements there is no need for using very thick wall of the container. This helps to reduce the total weigh of the system as well as to dissipate heat generated within the watertight container. The application of the cooling radiators in the capsules of selected modules provides an effective way of carrying heat away from electric power elements, which additionally improves the reliability of the underwater electric systems. At the same time, by locating some components of electric systems directly in the dielectric medium which fills the container with these systems, material saving is achieved, as not every component of these systems has to be located in a protective capsule.

### Description of an embodiment

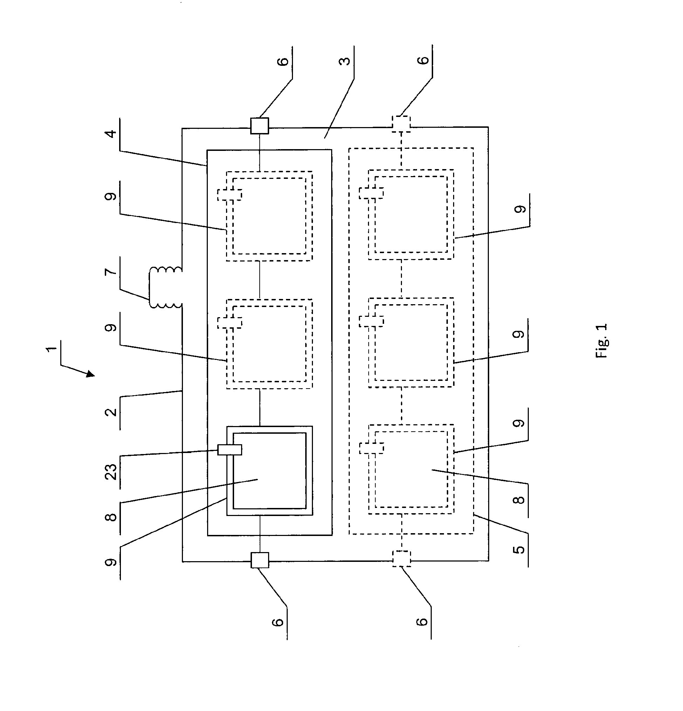

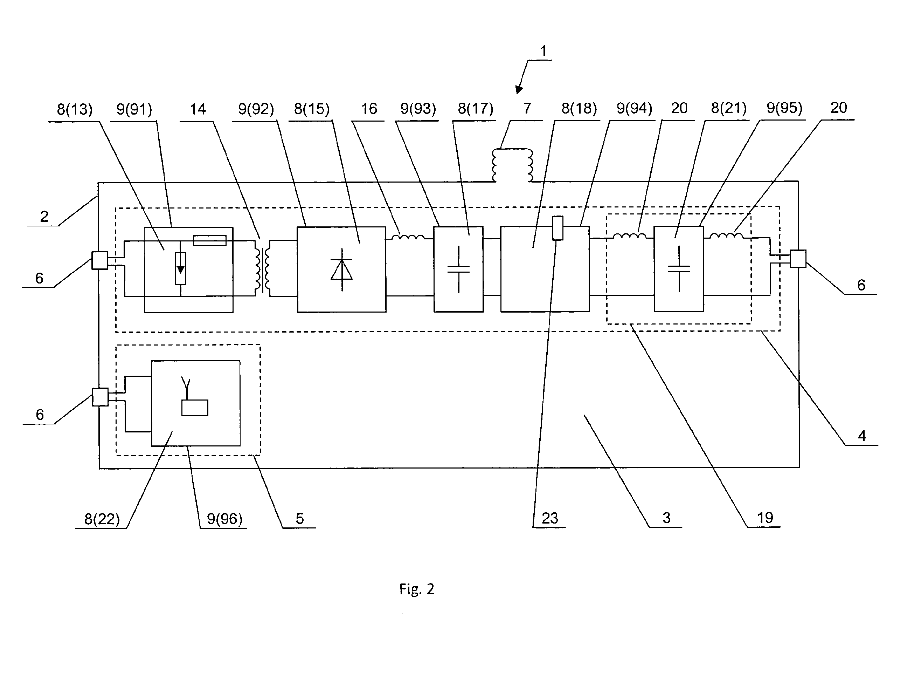

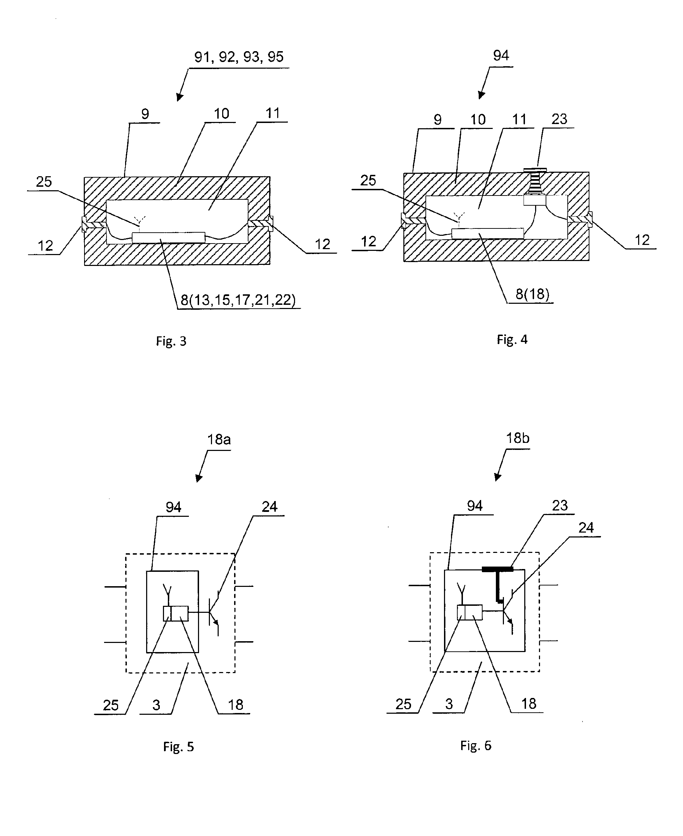

The invention is presented as an embodiment in the drawing where fig. 1 shows the modular system in a schematic view, fig. 2 shows the system from fig.1 in more detailed view, fig. 3 shows the capsule having means for transferring heat placed in penetrators in a cross section, fig. 4 shows capsule having additional means for transferring heat in the form of the radiator in a cross section, fig. 5 shows the inverter module from the system presented in fig. 2 in the first version of the embodiment, in a schematic view, fig. 6 shows the inverter module from the system presented in fig. 2 in the second version of the embodiment, in a schematic view.

The modular electric system 1 is placed in sea water environment at significant depth resulting in the exposure to high pressure. The modular device can be fixed to support structures located at the sea bed or it can be fixed to a submerged platform and it is supplied with electrical energy from the electrical source in a known way. The modular device 1 comprises a metal watertight container 2 filled with non-comprenssible dielectric liquid 3 of a pressure similar to the pressure surrounding the container 2 from external side of the container, in which there is at least one electric system 4. In the case where are more electric systems one of it can be a control system 5. The container 2 is furnished with electric bushings 6 which are tightly fixed in the container walls, for incoming and/or outgoing leads of electric systems 4 and of the control system 5. In one of the walls of the container 2 there is located a compensating element 7 which compensates for increase in the pressure of the liquid 3 filling the container 2 resulting from thermal expansion of the liquid and Of the components of the system. The dielectric liquid 3 in the container 2 is oil having insulating properties and of a pressure close to the pressure of water outside the container 2. For example on the depth about 1000m the pressure of the oil in the container is about 100 bar i.e. near the same as in the sea water outside the container. The electric system 4 and/or the control system 5 contains some modular functional electrical elements 8 which are placed in a protective insulating capsule 9 having a walls 10 made from resin-based composite material. The capsule 9 is filled with an insulating medium 11 in the form of electrically insulating gas, such as nitrogen or sulphur hexafluoride SF₆. The insulating medium can also be a porous substance of compressible properties, for instance, in the form of polyurethane foam. The insulating medium can also be a dielectric liquid in which any known pressure compensator is located, which is not shown in the drawing. The pressure of the insulating medium 11 is significantly lower than the pressure in the container 2. For example the pressure of the insulating medium is about 1 atm. In the walls 10 of the capsules 9 penetrators 12 are located, in which the inputs/outputs of the electrical elements 8 of the systems 4 or 5 are fitted. The electrical elements 8 generate the heat during the operation of the electrical system 4 so capsules of the electrical system 4 and/or control system is furnished with means for transferring the heat from these elements outside the insulating capsule 9 of the system 4 or 5 which contain functional elements 8 needed to be cooled. These means for transferring heat could be made of electrically conductive material in the form of penetrators 12 which are extending through the wall 10 of the capsule 9 and have an electrical connection to the modular functional electrical element 8. In the preferred embodiment of the invention the electric system 4 contains one of the module 9 in the form of the inverter which is furnished with the wireless communication means. In this case the control system 5 also is furnished with such means. The details of this embodiment are presented in later part of the description.

A more detailed an exemplary system of the invention presented on fig.2 comprises the first capsule 91 containing a protective module 13 with overvoltage limiters and fuses, schematically shown on the drawings, which is electrically connected with the primary side of a transformer 14. The secondary winding of the transformer 14 is electrically connected with the input of a rectifier module 16 schematically marked by the diode symbol, located in the second capsule 92. The output of the rectifier module 15 is electrically connected with a reactor 16 which is then connected with a capacitor unit module 17, placed in the third capsule 93, schematically marked in the drawing by the capacitor symbol. The capacitor unit module 17 is electrically connected with an inverter module 18, located in the forth capsule 94. The inverter module can be made in two versions 18a or 18b depending on the operating requirements of the system, which is presented fig. 4 and fig.5. The output of the inverter module 18 is electrically connected with the input of a LCL filter system 19 containing input/output coils 20 and a filter capacitor module 21 located in the fifth capsule 95. The control system 5 contains a control module 22, placed in the sixth capsule 96. The input of the protective module 13, the output of the LCL filter system 19 and the input/output of the control system 5 are electrically connected with electric sockets, not shown in the drawing, located in the bushings 6, respectively. Due to the location of the electric system 4 and the control system 5 in the dielectric liquid 3, the protective module 13, the rectifier module 15, the capacitor unit module 17, the filter capacitor module 21 and the control module 22 are provided with protective capsules 91-96. Each of these capsule 91-96 could be furnished with additional means for transferring the heat from the functional module 13, 15, 17, 18, 21, 22 into the liquid 3. As an exemplary embodiment of such means the radiator 23 is presented in the inverter module 18. The inverter module 18 is made in two versions which are presented on fig.5 and 6. In the first version, the inverter module 18a located in a capsule 94 contains power electronic switches 24, which are located outside the capsule 94 in the environment of the liquid 3 filling the container 2, and the wireless communication means 25 for wireless communication with the control system 5. In this case the control system 5 is also furnished with the wireless communication means for wireless communication with the electric system 4, which are placed in the capsule 9, what is indicated in fig.3 and 4 by dotted lines. The wireless communication means can be a radio frequency transmitting/receiving system. Other types of communication means not requiring galvanic connection, known to the those skilled in the art, such as magnetic or capacitive coupling, acoustic or optical, for example, are possible. In the second version, the inverter module 18b located in a capsule 94 contains power electronic switches 24 which are located inside the capsule 94. Power electronic switches 24 is connected with wireless communication means 25 for wireless communication with the control system 5 similar like in version 18a. In this case the cooling system is such simple as penetrators 12 is not sufficient and radiator 23 is placed in the wall 10 of the capsule 9. Usually, the radiator 23 has the form of a metal element, on one side connected with the surface of the modular functional electrical element 8, which generates heat during operation, and on the other side protruding above the outside surface of the capsule 9. Radiators of the presented design can be mounted also in the capsules 91, 92, 93, 95 belonging to the electric system 4 or in the capsule 96 of the control system 5, which are not shown in the drawing.

In operating conditions, the modular electric system is supplied with alternating current from a current source not shown in the drawing, and then the system 1 supplies underwater electric equipment, for instance induction motors that drive rotating machinery working in offshore oil and gas production systems, not shown in the drawing.

The key of the drawing:
1. a modular electric system
2. a metal watertight container
3. non-comprenssible dielectric liquid
4. an electric system
5. a control system
6. bushing
7. a compensating element
8.a modular functional electrical element
9. (91, 92, 93, 94, 95, 96). capsule
10. a wall of the capsule
11. an insulating medium
12.a penetrator
13.a protective module
14. a transformer
15. a rectifier module
16. a reactor
17. a capacitor unit module
18. (18a, 18b). an inverter module
19. a L CL filter system
20. coils of the LCL filter system
21.a filter capacitor module
22.a control module
23. a radiator
24. power electronic switches
25. wireless communication means

## Claims

1. A modular electric system (1) placed under water in a watertight container (2) provided with electric bushings (6), comprising at least one electric system (4) which comprise modular functional electrical elements (8) placed in a protective insulating capsule (9), **characterized in that** the electric system (4) is located in a closed container (2) filled with a dielectric non-compressible liquid (3) of a pressure similar to the pressure surrounding the container (2) from external side of the container, and at least one of the protective capsules (9) contains an insulating medium (11) of a pressure significantly lower than the pressure in the container (2) and at least one of the protective capsules (9) is furnished with means (12) and/or (23) for transferring heat generated by modular functional electrical elements (8).

2. A system according to claim 1, **characterized in that** the means for transferring heat generated in modular functional electrical elements (8) are made of electrically conductive material placed in the penetrators (12) located in the wall (10) of the capsule (9) and have an electrical connection to the modular functional electrical element (8).

3. A system according to claim 1, **characterized in that** the means (23) for transferring heat generated in modular functional electrical elements (8) are located in the wall (10) of the capsule (9) extending from the inside of the wall (10) to the outside of the capsule (9).

4. A system according to claim 1, **characterised in that** that the electric system (4) contains an inverter (18) for converting the direct current voltage into alternating current voltage.

5. A system according to claim 4, **characterized in that** the inverter module (18) is connected by wireless communication means (25) with a control system (5) placed in the watertight container (2).

6. A system according to claim 5, **characterized in that** the inverter module (18a) of the electric system (4) contains power electronic switches (24) located outside the protective capsule (9, 94) which are connected with wireless communication means (25) of the inverter (18a).

7. A system according to claim 5, **characterized in that** the inverter module (18b) of the electric system (4) contains power electronic switches (24) located inside the protective capsule (9, 94) which are connected with wireless communication means (25) of the inverter (18b) and the inverter module (18b) has a radiator (23) tightly fitted in the wall (10) of the capsule (9, 94).

8. A system according to claim 1, **characterized in that** the watertight container (2) is provided with a component that compensates for the pressure inside the container, in the form of compensating bellows (7).

9. In a system according to claims 1 to 8 the dielectric liquid (3) that fills the watertight container (2) is oil.

10. In a system according to claims 1 to 9, the insulating medium (11) filling the capsules (9) is an electrically insulating gas.

11. In a system according to claims 1 to 9, the insulating medium (11) filling the capsules (9) is a porous substance of compressible properties.

12. In a system according to claim 1 to 9 the insulating medium (11) filling the capsules (9), is a dielectric liquid with a pressure compensator located in the liquid.

13. In a system according to claim 1 to 12 the capsule (9) is made of an epoxy resin-based composite material.

14. In a system according to claim 1 to 12 the capsule (9) is made of elastomer.
